# EUROPEAN PATENT SPECIFICATION

(11) **EP 2 833 416 B1**
(45) Date of publication and mention of the grant of the patent: **10.11.2021**
(21) Application number: 13768783.6
(22) Date of filing: 18.03.2013
(51) Int. Cl.: H01L 31/042

(54) **BACK CONTACT SOLAR CELL MODULE**
SOLARZELLENMODUL MIT RÜCKSEITENKONTAKT
MODULE DE CELLULES SOLAIRES TYPE À CONTACT ARRIÈRE

(30) Priority: 30.03.2012 JP 2012080915; 26.11.2012 JP 2012258021
(43) Date of publication of application: 04.02.2015
(73) Proprietor: DSM Advanced Solar B.V., 6167 RD Geleen (NL)
(72) Inventor: KAWASAKI Minoru, Tokyo 110-8560 (JP); MATSUMASA Kenji, Tokyo 110-8560 (JP); KUDO Shigeki, Tokyo 110-8560 (JP); YAMAMOTO Mayumi, Tokyo 110-8560 (JP); AKENO Yasutake, Tokyo 110-8560 (JP); NISHIZAWA Tomo, Tokyo 110-8560 (JP); OKUBO Toru, Tokyo 110-8560 (JP)
(74) Representative: Vandevijver, Pascale
(86) International application number: PCT/JP2013/057645
(87) International publication number: WO 2013/146414

(56) References cited:
- JP-A- H06 334 207
- JP-A- 2002 151 712
- JP-A- 2002 151 712
- JP-A- 2011 091 303
- JP-A- 2011 091 303
- JP-A- 2011 096 777
- JP-A- 2011 096 777
- JP-A- 2011 159 748
- US-A1- 2011 272 006
- None

## Description

### TECHNICAL FIELD

The present invention relates to a solar cell module (back contact solar cell module) using a back contact solar cell, and particularly, to a material that is used in the back contact solar cell module.

Priority is claimed on Japanese Patent Application No. 2012-080915, filed March 30, 2012 and Japanese Patent Application No. 2012-258021, filed November 26, 2012.

Prior art which is related to this field is disclosed in document JP 2011-096777 showing base material for back surface protective sheet for solar cell, and back surface protective sheet for solar cell.

### BACKGROUND ART

A solar cell constitutes the heart of a photovoltaic power generation system that directly converts solar energy to electricity, and is formed from a semiconductor.

In addition, with regard to a use of the solar cell, a solar cell element (cell) simple body is not used as it is, and a unit, in which several sheets to dozens of sheets of solar cell elements that are interconnected in series or in parallel are packaged in various packages for protection of the solar cell elements for a long period of time, is generally used.

The unit that is assembled into a package is called a solar cell module. Generally, in the solar cell module, a surface that is exposed to sunlight is covered with front glass, and a gap is filled with a filler formed from thermoplastic plastic.

In addition, a rear surface of the solar cell module is protected by a sheet (back sheet) that is formed from a plastic material having heat resistance, humidity resistance, water resistance, weather resistance, and the like.

The solar cell module is used outdoors. Therefore, with regard to constituent members, a material and structure of the constituent members, and the like, the solar cell module is demanded to have sufficient heat resistance, weather resistance, water resistance, humidity resistance, wind pressure resistance, light resistance, hailstorm resistance, chemical resistance, humidity resistance, antifouling properties, light reflectivity, light diffusibility, and other characteristics.

As the solar cell element, for example, a crystalline silicon solar cell element is used. The solar cell module is manufactured by using a lamination method (vacuum lamination) in which a surface protective sheet layer, a filler layer, a solar cell element as a photovoltaic element, a filler layer, a rear surface protective sheet layer, and the like are laminated in this order, and the resultant laminated body is heated and compressed during vacuum suction.

A silicon crystal has been used in a current mainstream solar cell element.

In a solar cell of the related art, an n-type electrode is provided on a light receiving surface that receives sunlight, and a p-type electrode is provided on a rear surface.

The n-type electrode that is provided on the light receiving surface is necessary for an extraction of a current. On the other hand, the sunlight is not incident to a substrate provided under the n-type electrode. Therefore, electricity is not generated at a portion to which the sunlight is not incident. Accordingly, in a case where an area of the electrode provided on the light receiving surface is large, photoelectric conversion efficiency of the solar cell decreases. In addition, loss of light due to the electrode provided on the light receiving surface is called shadow loss.

A solar cell in which an electrode is not present on the light receiving surface, and the p-type electrode and the n-type electrode are formed on the rear surface is called a rear surface electrode type solar cell, a back contact cell, and the like. In this type of solar cell (back contact solar cell), the shadow loss due to an electrode is not present, and 100% of sunlight that is incident to the light receiving surface can be taken into the solar cell. Accordingly, it is possible to realize principally high photoelectric conversion efficiency (Patent Document 1 to Patent Document 3).

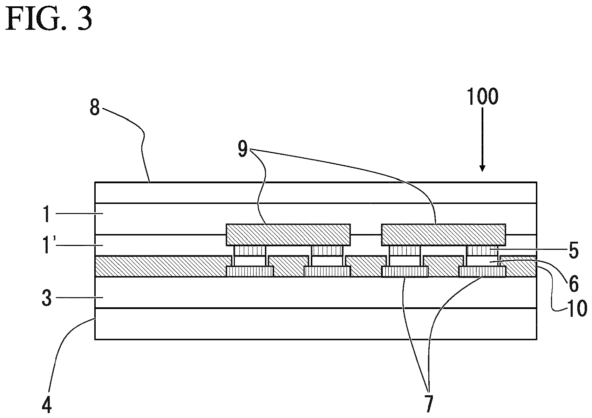

FIG. 3 shows an example of a cross-sectional view in a back contact solar cell module having a general structure.

In a solar cell module 100 shown in FIG. 3, a front glass 8, a transparent sealing material 1, a back contact cell 9, a transparent sealing material 1', an electrical insulating layer 10, a circuit sheet (base film) 3, and a back sheet 4 are laminated in this order from a light receiving surface (front surface) side. In addition, when solder or silver paste 6 connects a cell electrode 5 that is provided at a rear surface of the back contact cell 9 and metal foil 7 that is patterned on a front surface of the circuit sheet 3, power may be taken out.

As a representative method of manufacturing the solar cell module 100, there is a method of manufacturing a solar cell module by using a typical molding method such as a lamination method in which the transparent sealing material 1, the back contact cell 9, the transparent sealing material 1', the electrical insulating layer 10, the circuit sheet 3, and the back sheet 4 are laminated on the front glass 8 in this order, and the resultant laminated body is heated and compressed during vacuum suction, thereby integrally molding the respective layers.

As described above, in the circuit sheet for the back contact cell of the related art, an electrical insulating layer (ILD: Inter Layer Dielectrics) that is disposed on metal foil that is patterned is necessary. The ILD is called a solder resist. However, a material of the ILD is expensive, and it is necessary for the ILD to have a thickness to a certain degree. Therefore, the manufacturing cost of the back contact solar cell module of the related art is higher than that of a solar cell module of the related art in which electrodes are provided on both of the light receiving surface and the rear surface.

In addition, when forming the ILD, a thermal crosslinking or UV crosslinking process is necessary after printing the ILD in many cases. Particularly, the thermal crosslinking process is typically performed at 100°C to 160°C for 10 minutes to 60 minutes.

Therefore, in the thermal crosslinking process, the following problems and the like may occur. Specifically, time is taken in the thermal crosslinking process and thus production efficiency may decrease. In addition, thermal deterioration of a material other than the insulating layer may be promoted or the module may be bent due to heating for thermal crosslinking. In addition, dimensional accuracy may deteriorate due to thermal contraction.

### PRIOR ART DOCUMENTS

### PATENT DOCUMENTS

[Patent Document 1] Japanese Unexamined Patent Application, First Publication No. 2005-11869
[Patent Document 2] Japanese Unexamined Patent Application, First Publication No. 2010-212630
[Patent Document 3] Japanese Unexamined Patent Application, First Publication No. 2011-159748

Patent application JP 2011096777 A discloses a back contact solar cell module comprising a back sheet, a circuit sheet laminated on the back sheet, and an insulating layer between the circuit sheet and the back contact solar cells.

### SUMMARY OF THE INVENTION

### PROBLEMS TO BE SOLVED BY THE INVENTION

An object of the invention is to improve productivity of a back contact solar cell module and to further increase insulation properties of the back contact solar cell module by providing an insulating film as an intermediate layer on an upper surface of a circuit sheet for the back contact solar cell module in a crystalline solar cell having high photoelectric conversion efficiency instead of providing the electrical insulating layer (ILD) formed by a coating printing method that is generally employed in a printed circuit board, thereby omitting the thermal crosslinking process necessary after ILD printing.

In addition, another object of the invention is to provide a solar cell module which has characteristics for protection of respective constituent elements of the solar cell module, which can be molded and processed by a typical method, which can be manufactured at a low cost, which is excellent in stability and durability, and which has particularly stable and high power conversion efficiency.

### MEANS FOR SOLVING THE PROBLEMS

As means for solving the above-described problems, the back contact solar cell module of the invention is defined in claim 1 and has the following configurations.

In addition, in the following description, the term "front surface (light receiving surface)" represents a surface that faces a direction of the sun during use of a solar cell module, and the term "rear surface" represents a surface that faces a direction opposite to the direction of the front surface (light receiving surface).

According to an aspect of the invention, a back contact solar cell module including: a back sheet; a circuit sheet laminated on the back sheet, the circuit sheet having an interconnection pattern on a front surface thereof; an insulating-layer-provided sealing material having a through-hole, the insulating-layer-provided sealing material being laminated on the circuit sheet, the insulating-layer-provided sealing material being constituted by an insulating film and a pair of sealing material layers provided on both surfaces of the insulating film; a back contact cell formed on the insulating-layer-provided sealing material, the back contact cell having a cell electrode on a rear surface thereof; a transparent sealing material laminated to cover the insulating-layer-provided sealing material and the back contact cell; a transparent base material laminated on the transparent sealing material; and a conductive paste provided in the through-hole, the conductive paste electrically and physically connecting the cell electrode and the interconnection pattern to each other.

The insulating film may be one of a white film, a black film, and a colored film.

The insulating film may contain at least one of polypropylene (homo, random, block), polyester, polyamide, a polyimide film, and polyethylene which is thermally fusible to a sealing material resin.

The interconnection pattern may be one of aluminum foil and copper foil.

The transparent base material may be a glass plate.

A color of the back sheet may be white.

### Effects of Invention

According to the back contact solar cell module relating to the aspect of the invention, the solar cell module is constituted by using a back contact single crystal silicon solar cell in which an electrode is not present on the light receiving surface and a p-type electrode and an n-type electrode are formed on the rear surface, a back contact polycrystalline silicon solar cell, or a back contact hetero-junction crystal (so-called "HIT", manufactured by SANYO Electric Co., Ltd.) silicon solar cell. Accordingly, electrodes, which are provided on rear surfaces of solar cells adjacent to each other, can be connected to each other. As a result, a plurality of solar cells can be easily connected in series.

In addition, in a case where each of the solar cells has a rectangular shape in which a corner portion is cut out, a gap is formed at a portion surrounded by four solar cells that are arranged side by side vertically and horizontally. This gap serves as a buffer space, and thus it is possible to prevent fatigue fracture of the solar cell module due to thermal expansion and contraction of the solar cell and the like.

In addition, in a case where the insulating film is a white film, a black film, or a colored film, it is possible to make the interconnection of the circuit sheet provided inside the solar cell module invisible.

In addition, a highly reflective sheet or a prism sheet may be used as the colored film in order to obtain a different external appearance due to coloring with a different color, and in order for light, which goes through the gap between adjacent solar cells and which is not absorbed by the front surface (light receiving surface) of the solar cells, to be reflected from the colored film and to be absorbed by the front surface (light receiving surface) of the solar cells, thereby improving power generation efficiency of the solar cell module.

In addition, in a case where the interconnection pattern is aluminum foil or copper foil, processing is easy in comparison to a conductive plastic film, a conductive paste, and the like. Accordingly, it is possible to manufacture the solar cell module at a low cost.

In addition, in a case where the transparent base material is the glass plate, the glass plate has rigidity higher than that of a film-shaped or plate-shaped light-transmitting resin, and thus it is possible to protect the front surface of the solar cell module and it is possible to increase the rigidity of the solar cell module.

In addition, the glass plate has a light transmittance higher than that of the film-shaped or plate-shaped light-transmitting resin, and thus it is possible to efficiently use sunlight.

In addition, the glass plate has a coefficient of thermal expansion lower than that of the film-shaped or plate-shaped light-transmitting resin, and thus fatigue of the solar cell and an interconnector due to thermal expansion and thermal contraction of the transparent base material is small.

In addition, in a case where the color of the back sheet is white, the sunlight incident to a gap of adjacent solar cells is reflected from the white back sheet and the front surface of the solar cell module, and thus the reflected sunlight can be incident to the solar cells. As a result, loss of the sunlight is suppressed. That is, it is possible to effectively use the sunlight. Accordingly, it is possible to improve power generation efficiency of the solar cell module.

Here, a white portion of the white back sheet may be formed by a white film, or may be coated in a white color. In addition, the white portion may be formed by laminating a white film on an upper surface of the film. In addition, the white portion may be formed by white glass or a white resin plate. In addition, an interconnection side sealing material may contain a white pigment to obtain the same effect as the white back sheet. On the other hand, in a case where the white pigment is added to a cell side sealing material, there is a possibility that a colored resin moves to the front surface of the cell and shields light, and thus this case is not preferable.

As described above, according to the back contact solar cell module relating to the aspect of the invention, it is possible to obtain a solar cell module which is excellent in various physical properties and in which productivity and cost performance are high.

### BRIEF DESCRIPTION OF THE DRAWINGS

FIG. 1 is a cross-sectional view showing an example of a configuration of a back contact solar cell module according to an embodiment of the invention.
FIG. 2 is a cross-sectional view of an insulating-layer-provided sealing material in the back contact solar cell module shown in FIG. 1.
FIG. 3 is an example of a cross-sectional view of a back contact solar cell module of the related art which has a general structure.

### EMBODIMENTS FOR CARRYING OUT THE INVENTION

Hereinafter, an embodiment of the invention will be described in detail with reference to the attached drawings.

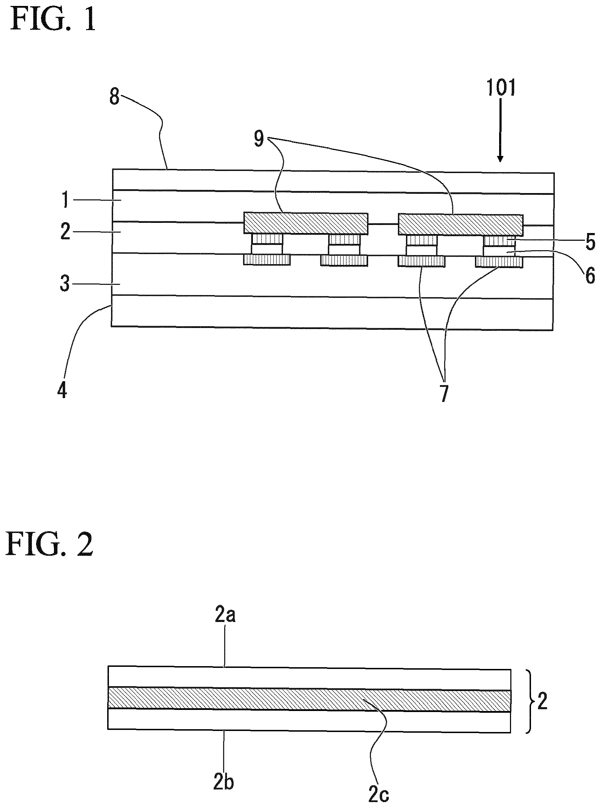

FIG. 1 is a cross-sectional view showing an example of a configuration of a back contact solar cell module according to an embodiment of the invention. FIG. 2 is a cross-sectional view of an insulating-layer-provided sealing material in the back contact solar cell module shown in FIG. 1.

As shown in FIGS. 1 and 2, the back contact solar cell module 101 according to an embodiment of the invention includes a back sheet 4, a circuit sheet 3 which is laminated on the back sheet 4 and which has an interconnection pattern 7 such as metal foil on a front surface thereof, an insulating-layer-provided sealing material 2 having a through-hole 11 which is laminated on the circuit sheet 3 and which is constituted by an insulating film 2c, a cell side sealing material 2a that is provided on a front surface of the insulating film 2c, and a circuit sheet side sealing material 2b that is provided on a rear surface of the insulating film 2c, a back contact cell 9 which is formed on the insulating-layer-provided sealing material 2 and which has a cell electrode 5 on a rear surface thereof, the cell electrode 5 taking out electrons from a p-type electrode and an n-type electrode which are formed on the rear surface thereof, a transparent sealing material 1 that is laminated to cover the insulating-layer-provided sealing material 2 and the back contact cell 9, a transparent base material 8 such as front glass which is laminated on the transparent sealing material 1, and a conductive paste 6 such as solder and silver paste which is provided in the through-hole 11 and which electrically and physically connects the cell electrode 5 and the interconnection pattern 7.

The transparent base material 8, which is used in the back contact solar cell module according to an embodiment of the invention, is demanded to have a function of having a satisfactory light transmittance, a function in which weather resistance is excellent for a long period of time (approximately 20 years) and a decrease in the light transmittance is small, a function to which dust and the like are less likely to adhere, a function in which damage is not likely to occur, a function of having a very small water vapor transmittance, and the like. As a material of the transparent base material 8, glass is general, but an acrylic resin, a polycarbonate resin, a silicon resin, a fluorine-based resin, a composite film containing these resin films as a constituent material, and the like are also possible.

The transparent sealing material 1, which is used in the back contact solar cell module according to the embodiment of the invention, is demanded to have a function of having a high solar light beam transmittance, a function in which a variation in a physical property of the transparent sealing material 1 such as a decrease in a light beam transmittance when the transparent sealing material 1 is left outdoors for a long period of time does not occur, a function of having high insulation resistance, a function of not corroding other material, a function in which cracking in a resin and interfacial peeling due to a rapid variation in outdoor air conditions do not occur, and the like. For example, as a material of the transparent sealing material 1, a polyvinyl butylal (PVB) resin, a silicon resin, a vinyl chloride resin, a polyurethane resin, and the like are preferable.

Specifically, as the material of the transparent sealing material 1, a transparent resin of an olefin type and the like such as EMMA, EAA, ionomer, and polypropylene is preferably used, and ethylene-vinyl acetate copolymer (EVA) resin is particularly preferable.

As the thickness of the transparent sealing material 1, a range of 100 µm to 1000 µm is appropriate. When the thickness of the transparent sealing material 1 is less than 100 µm, the solar cell may be cracked. When the thickness of the transparent sealing material 1 exceeds 1000 µm, the production cost increases.

The insulating-layer-provided sealing material 2 is basically constituted by three layers of: the cell side sealing material layer 2a, the insulating film 2c, and the circuit sheet side sealing material layer 2b.

An anchor coat or an adhesive layer may be provided between the sealing material layer and the insulating film.

In addition, as the total thickness of the insulating-layer-provided sealing material 2, a range of 100 µm to 1000 µm is preferable. When the total thickness of the insulating-layer-provided sealing material 2 is less than 100 µm, sufficient shielding properties or an effect of sufficiently improving power generation efficiency may not be obtained. In addition, there is a possibility that the solar cell may be cracked.

When the total thickness of the insulating-layer-provided sealing material 2 exceeds 1000 µm, the production cost increases.

In addition, before performing lamination, it is necessary to open a hole (through-hole) for electrical connection at a contact portion of a cell electrode in the insulating-layer-provided sealing material 2 to connect the cell electrode and an interconnection pattern of the circuit sheet with solder, silver paste, or the like in a subsequent process.

It is necessary for the cell side sealing material layer 2a to come into strong contact with the transparent sealing material 1, and it is necessary for the circuit sheet side sealing material layer 2b to come into strong contact with a base film that is used in the circuit sheet 3. The cell side sealing material 2a and the circuit sheet side sealing material layer 2b are appropriately selected among combinations that satisfy these conditions.

As a raw material of the cell side sealing material layer 2a, an olefin type resin such as an EVA (ethylene-vinyl acetate copolymer)-based sealing material, EMMA (ethylene-methyl methacrylate copolymer), EAA (ethylene-acrylate copolymer), ionomer, and polypropylene, and a transparent type such as PVB (polyvinyl butylal) and a silicon resin is used.

As the thickness of the cell side sealing material layer 2a, a range of 10 µm to 500 µm is appropriate. In a case where the thickness of the cell side sealing material 2a is less than 10 µm, a step difference of a cell and the like cannot be filled, and thus the cell side sealing material 2a does not function as a filler. In addition, in a case where the thickness of the cell side sealing material 2a exceeds 500 µm, the production cost increases.

A raw material of the circuit sheet 3 side sealing material 2b comprises an olefin type resin such the EVA-based sealing material, the EMMA, the EAA, the ionomer, and the polypropylene, the PVB (polyvinyl butylal), and the silicon resin. As the thickness of the circuit sheet side sealing material layer 2b, a range of 1 µm to 500 µm is appropriate. When the thickness of the circuit sheet side sealing material layer 2b is less than 1 µm, a step difference of the interconnection pattern cannot be filled. In addition, when the thickness of the circuit sheet side sealing material layer 2b exceeds 500 µm, the production cost increases.

As the insulating film 2c, a stretched polyester film, a stretched polyamide film, a fluorine film, or a polyimide film is used.

In addition, as the insulating film 2c, an olefin-based film constituted by polypropylene (homo, random, block) or polyethylene (high density, intermediate density), which is thermally fusible to the sealing material resin and which has a relatively higher melting point, also may be used. In addition, the film may contain one or more kinds of the above-described resins. When the film and the sealing material are thermally fusible, an anchor coat or an adhesive is not necessary for the film, and thus it is possible to reduce the cost thereof.

In addition, as the insulating film 2c, it is also possible to use a colored film of a white color, a black color, and the like so as to make an interconnection of the circuit sheet disposed at the inside of the solar cell module invisible. In addition, a highly reflective film or a prism sheet may be used as the insulating film 2c in order for light, which goes through the gap between adjacent solar cells, to be reflected from the insulating film 2c and to be absorbed to the front surface of the solar cells, thereby improving power generation efficiency of the solar cells.

As the thickness of the insulating film 2c, a range of 3 µm to 200 µm is appropriate. When the thickness of the insulating film 2c is less than 3 µm, a sufficient insulation performance is not obtained. In addition, when the thickness of the insulating film 2c exceeds 200 µm, the production cost increases.

As the insulation performance of the insulating film 2c, in JIS-Z-3197, an insulating volume resistance value of 1×10¹⁰ Ω· cm or more is obtained.

In addition, the insulating-layer-provided sealing material 2 may be constituted by three layers including the cell side sealing material 2a in which a melting point of at least one of the constituent resins is as low as 120°C or lower, the insulating film 2c in which the melting point of at least one of the constituent resins is as high as 130°C or higher, and the circuit sheet side sealing material 2b in which the melting point of at least one of the constituent resins is as low as 120°C or lower.

In a case of performing vacuum lamination at a temperature of 130°C to 160°C which is a typical vacuum lamination condition, the cell side sealing material layer 2a and the circuit sheet side sealing material layer 2b, which have a low melting point, are melted. On the other hand, the insulating film 2c having a high melting point is not melted. Accordingly, even when foreign matter is embedded in the insulating-layer-provided sealing material 2, the film thickness of the insulating film 2c is retained (that is, the film thickness of the insulating film 2c does not decrease), and thus the insulation properties of the insulating-layer-provided sealing material 2 are secured.

Accordingly, even when foreign matter is present in the cell side sealing material layer 2a and the circuit sheet side sealing material layer 2b during vacuum lamination, a decrease in the insulation properties of the insulating-layer-provided sealing material 2 and an occurrence of short circuit failure between the cell electrode 5 and the interconnection pattern 7 may be reduced. In addition, it is not necessary to provide the electrical insulating layer (ILD) for securement of the insulation properties, and thus it is possible to prevent the production cost from increasing in comparison to the related art in which the electrical insulating layer (ILD layer) is provided.

In addition, the insulating-layer-provided sealing material 2 may be a laminated body that is formed by an extrusion lamination method.

As the circuit sheet 3 having the interconnection pattern 7 such as metal foil on a front surface, a sheet, in which a stretched polyester film such as a stretched polyethylene terephthalate (PET) film and a stretched polyethylene naphthalate (PEN) film or a heat-resistant film such as a polyimide film is set as a base film, and a circuit pattern is formed with metal foil and the like on a surface of the base film, is used.

As a conductive material that forms the interconnection pattern 7, metal foil, and particularly, copper foil, aluminum foil, and the like are used in consideration of easy processing and low cost. However, as the conductive material that forms the interconnection pattern 7, a conductive plastic film, a conductive paste, and the like may be used.

As a method of patterning the interconnection pattern 7, a method of etching the metal foil, a method of printing metal paste, a method of punching (or blanking) the metal foil, and the like may be used.

The back contact solar cell module according to the embodiment of the invention may be provided with the back sheet 4 such as a plastic film for protection of a rear surface thereof, and the like.

A raw material of the plastic film that is used in the back sheet 4 of the back contact solar cell module according to the embodiment of the invention may be appropriately selected polyester films such as polyethylene terephthalate (PET), polybutylene terephthalate (PBT), and polyethylene naphthalate (PEN), polyolefin films such as polypropylene (PP) and polyethylene (PE), films such as polyphenylene sulfide (PPS) and polyamide, polyvinyl fluoride (PVF), and the like.

As the back sheet 4, the plastic films are used in a single layer, but examples of a general back sheet include a back sheet constituted by three layers of a fluorine resin/PET/a fluorine resin, and a back sheet constituted by three layers of hydrolysis-resistant PET/PET/an anchor coat.

In accordance with a quality that is demanded, for example, aluminum film, a deposited film, and the like for prevention of moisture may be added to the back sheet 4.

In addition, the back sheet 4 may be formed integrally with the circuit sheet 3, or may be formed independently from the circuit sheet.

The conductive paste 6 such as solder and silver paste is provided between the cell electrode 5 and the interconnection pattern 7 such as metal foil, and electrically and physically connects both of these.

There is no special restriction on the conductive paste 6 except that the conductive paste 6 is a thermally fusible conductive metal. However, solder or silver paste is preferably used as the conductive paste 6 since the solder or silver paste is cheap and is easy to use.

Next, an example of a method of manufacturing the back contact solar cell module according to the embodiment of the invention will be described with reference to FIGS. 1 and 2.

First, a PVF film (25 µm) as the back sheet 4, a PET film (250 µm) as the base film for the circuit sheet 3, and electrolytic copper foil (35 µm) as the metal foil that forms the interconnection pattern 7 are bonded by a dry lamination method using a urethane-based adhesive.

In addition, patterning is performed on an upper surface of the electrolytic copper foil by an etching method to form a back sheet on which a circuit having the interconnection pattern 7 is mounted.

Separately from the back sheet on which the circuit is mounted, an EVA-based sealing material is extruded to both surfaces of the transparent PET film 2c (50 µm) with a thickness of 75 µm by an extruding lamination method to prepare the insulating-layer-provided sealing material 2.

Next, a hole is opened at a portion of the insulating-layer-provided sealing material 2 which comes into contact with the electrode 5 provided on the rear surface of the solar cell.

Next, the back contact cell 9, the transparent sealing material 1, and the transparent base material 8 are disposed in this order to be superimposed on the back sheet on which the circuit is mounted, and then module lamination is performed by a module laminator to prepare the back contact solar cell module.

When superimposing the back sheet on which the circuit is mounted, the back contact cell 9, the transparent sealing material 1, and the transparent base material 8, silver paste is applied between the rear surface of the solar cell and a circuit sheet contact portion in order for the above-described members to be bonded to each other through heating during the module lamination.

As described above, the back contact solar cell module according to the embodiment of the invention is provided with the back contact cell 9 having the cell electrode 5 on a rear surface. The cell electrode 5 takes out electrons from a p-type electrode and an n-type electrode provided on the rear surface.

According to this, in the back contact solar cell module according to the embodiment of the invention, electrodes, which are provided on rear surfaces of solar cells adjacent to each other, can be connected to each other, and thus it is not necessary to curve an interconnector. Accordingly, it prevents disconnection of the interconnector.

On the other hand, in a solar cell module of the related art, it is necessary to connect an electrode provided on a light receiving surface of one of the two adjacent solar cells and an electrode provided on a rear surface of the other solar cell by interconnecting between the adjacent solar cells with the interconnector in a curved state. Accordingly, fatigue disconnection may occur at a curved portion of the interconnector due to thermal expansion and contraction of a protective member, a sealing material, and the like which constitute the solar cell.

In addition, in the back contact solar cell module according to the embodiment, an electrode is not present on the light receiving surface, and thus sunlight can be received by the entirety of the light receiving surface. Accordingly, the loss of the sunlight is small, and thus the sunlight can be efficiently used, and the external appearance of the solar cell module is preferable.

In addition, as described above, the back contact solar cell module according to the embodiment uses the back contact solar cell in which the p-type electrode and the n-type electrode are provided on the rear surface of the solar cell and the electrodes provided on the rear surface can be connected to each other, and thus it is possible to make a gap between adjacent cells small. Accordingly, it is possible to densely arrange solar cells side by side. As a result, it is possible to improve overall power generation efficiency of the solar cell module.

On the other hand, in the solar cell module of the related art, it is necessary to connect an electrode provided on a front surface of one of the two adjacent solar cells and an electrode provided on a rear surface of the other solar cell by interconnecting between the adjacent solar cells with the interconnector in a curved state. Therefore, it is necessary to make a gap between the adjacent cells large.

In addition, in the back contact solar cell module according to the embodiment, as described above, the back contact solar cell module according to the embodiment uses the back contact solar cell in which the p-type electrode and the n-type electrode are provided on the rear surface of the solar cell and the electrodes provided on the rear surface can be connected to each other, and thus it is not necessary for the interconnector to be interconnected between adjacent solar cells in a curved state. Accordingly, it is not necessary for the sealing material layer provided on the front surface and the rear surface of the solar cell to protect and buffer the interconnector. As a result, the sealing material layer of the solar cell can be formed with a small thickness. Accordingly, it is possible to realize a reduction in thickness and weight of the solar cell module.

In addition, as described above, the back contact solar cell module according to the embodiment uses the back contact solar cell in which the p-type electrode and the n-type electrode are provided on the rear surface of the solar cell and the electrodes provided on the rear surface can be connected to each other, and thus a plurality of solar cells are arranged side by side vertically and horizontally in a close-packed state in which a portion not contributing to power generation is small. Accordingly, it is possible to use a power generation effective area of the solar cell to the maximum extent.

In addition, a gap between adjacent solar cells that are arranged side by side may be left as a separating portion that is an insulating portion. However, it is preferable that this separating portion be as small as possible, and in this case, it is possible to reduce a portion that does not contribute to power generation.

In addition, the back contact solar cell module according to an embodiment of the invention includes the circuit sheet 3 having the interconnection pattern 7 on a front surface, the insulating-layer-provided sealing material 2 which is laminated on the circuit sheet 3 and which is constituted by the insulating film 2c, the cell side sealing material 2a that is provided on a front surface of the insulating film 2c, and the circuit sheet side sealing material 2b that is provided on a rear surface of the insulating film 2c, and the back contact cell 9 which is formed on the insulating-layer-provided sealing material 2 and which has the cell electrode 5 on a rear surface, the cell electrode 5 taking out electrons from a p-type electrode and an n-type electrode which are formed on the rear surface. That is, in the back contact solar cell module according to the embodiment of the invention, the insulating-layer-provided sealing material, which includes an insulating film and a pair of sealing material layers provided on both surfaces of the insulating film, is provided between the cell electrode that is provided on the rear surface of the back contact solar cell and the interconnection pattern that is provided on the front surface of the circuit sheet.

According to this configuration, the insulating-layer-provided sealing material has a function as a sealing material and a function as an electrical insulating layer. Accordingly, it is not necessary to separately provide the electrical insulating layer. As a result, it is possible to provide the solar cell module having high insulation properties in a simpler manner in comparison to a case where the ILD is provided separately from the sealing material by a coat printing method in which a thermal curing process is necessary.

### Examples

Specific Examples of the back contact solar cell module according to the embodiment of the invention will be described with reference to FIGS. 1 and 2, but the invention is not limited to Examples.

### <Example 1>

First, as Example 1, a PVF film "PV2111" (25 µm) manufactured by E. I. du Pont de Nemours and Company as the back sheet 4, a typical PET film "S10" (250 µm) manufactured by Toray Industries, Inc. as the base film for the circuit sheet 3, and electrolytic copper foil (35 µm) as the metal foil which forms the interconnection pattern 7 were bonded by a dry lamination method by using a two-liquid curing type urethane adhesive "A511/A50" manufactured by Mitsui Chemicals, Incorporated in such a manner that an adhesive layer having a thickness of 5 g/m² after drying of the adhesive is formed.

In addition, patterning was performed on an upper surface of the electrolytic copper foil by an etching method to form a back sheet on which a circuit having the interconnection pattern 7 was mounted.

Separately from the back sheet on which the circuit was mounted, an EVA-based sealing material "EF1001" manufactured by Toppan Printing Co., Ltd. was extruded onto both surfaces of the transparent PET film 2c "G2" (50 µm) manufactured by Teijin Limited with a thickness of 75 µm by an extruding lamination method to prepare the insulating-layer-provided sealing material 2 "EVA sealing material (75 µm)/transparent PET (50 µm)/EVA sealing material (75 µm)".

Next, a hole was opened in a portion of the insulating-layer-provided sealing material 2 which comes into contact with the electrode 5 provided on the rear surface of the solar cell.

Next, the back contact cell 9, the transparent EVA-based sealing material 1 (400 µm), and the front glass 8 were disposed in this order to be superimposed on the back sheet on which the circuit was mounted, and then module lamination was performed by a module laminator to prepare the back contact solar cell module.

When superimposing the back sheet on which the circuit was mounted, the back contact cell 9, the transparent EVA-based sealing material 1 (400 µm), and the front glass 8, silver paste was applied between the rear surface of the solar cell and a circuit sheet contact portion in order for the above-described members to be bonded to each other through heating during the module lamination.

In the module lamination, evacuation was performed at 145°C for three minutes, compression pressing was performed at 150°C for one minute, and thermal crosslinking was performed at 150°C for 15 minutes.

### <Example 2>

As Example 2, a back contact solar cell module was prepared by the same method and the same configuration as Example 1 except that a raw material of the insulating-layer-provided sealing material 2 was different.

As the insulating-layer-provided sealing material, an anchor coating material "TAKELAC A3210" manufactured by Mitsui Chemicals, Incorporated was anchor-coated on both surfaces of white PET "VW (50 µm)" manufactured by Teijin DuPont Films Japan Limited in such a manner that an application amount after drying became 1 g/m², and then an EMAA resin "Nucrel N0908C" manufactured by DU PONT-MISTUI POLYCHEMICALS was extruded by an extruder with a thickness of 50 µm to prepare the insulating-layer-provided sealing material 2 "EMAA (50 µm)/anchor coating (AC) layer/white PET (50 µm)/anchor coating (AC) layer/EMAA (50 µm).

### <Example 3>

As example 3, a back contact solar cell module was prepared by the same configuration and the same method as Example 1 except that a raw material of the insulating-layer-provided sealing material 2 was different.

As the insulating-layer-provided sealing material, a two-liquid curing type urethane-based dry laminate adhesive "A515" manufactured by Mitsui Chemicals, Incorporated was applied to both surfaces of black PET "VK (50 µm)" manufactured by Teijin DuPont Films Japan Limited in such a manner that an application amount after drying became 5 g/m², and dry lamination (DL) was performed. Then, "HM52 (50 µm)" manufactured by Tamapoly Film was bonded on the dry laminate, thereby preparing the insulating-layer-provided sealing material 2 "HM52 (50 µm)/DL/black PET (50 µm)/DL/HM52 (50 µm).

### <Example 4>

As Example 4, a back contact solar cell module was prepared by the same configuration and the same method as Example 1 except that a raw material of the insulating-layer-provided sealing material 2 was different.

When preparing the insulating-layer-provided sealing material, "EVA-based sealing material EF1001" manufactured by Toppan Printing Co., Ltd. was extruded onto both surfaces of a trial white olefin film (random PP: 50%, polyethylene: 50%) by an extruding lamination method with a thickness of 75 µm to prepare the insulating-layer-provided sealing material 2 "EVA sealing material (75 µm)/white olefin film (50 µm)/EVA sealing material (75 µm)".

### <Comparative Example 1>

As Comparative Example 1, a back contact solar cell module was prepared by the same configuration and the same method as Example 1 except that an EVA sealing material "EF1001 (200 µm)", which was the same as the transparent sealing material 1 that was the surface side sealing material, was used as a rear surface side sealing material corresponding to the insulating-layer-provided sealing material 2.

### <Comparative Example 2>

As Comparative Example 2, a back contact solar cell module was prepared by the same configuration and the same method as Example 1 except that an ionomer sealing material (400 µm) was used as the transparent sealing material 1, and a white ionomer sealing material (200 µm) was used as the rear surface side sealing material corresponding to the insulating-layer-provided sealing material 2.

### <Evaluation>

To verify a difference between the back contact solar cell modules prepared in Examples 1 to 4, and Comparative Examples 1 and 2 due to a difference in a configuration of the rear surface side sealing material, Examples 1 to 4, and Comparative Examples 1 and 2 were evaluated with respect to six items including productivity of the sealing material, insulation properties, color unevenness of the sealing material, color change of the sealing material, manufacturing cost, and lamination method.

Evaluation results are shown in Table 1. In evaluation results in Table 1, "⊚" represents "very excellent", "○" represents "passing", "×" represents "poor", and "-" represents "evaluation is impossible" .

**[Table 1]**

| <EVALUATION RESULTS OF SOLAR CELL MODULE> | | | | | | |
|---|---|---|---|---|---|---|
| | EXAMPLE 1 | EXAMPLE 2 | EXAMPLE 3 | EXAMPLE 4 | COMPARATIVE EXAMPLE 1 | COMPARATIVE EXAMPLE 2 |
| CONFIGURATION OF INSULATING-LAYER-PROVI DED SEALING MATERIAL | EVA | EMAA | IONOMER | EVA | | |
| | TRANSPARENT PET | WHITE PET | BLACK PET | WHITE OLEFIN FILM | TRANSPARENT EVA SIMPLE SUBSTANCE | WHITE IONOMER |
| | EVA | EMMA | IONOMER | EVA | | |
| PRODUCTIVITY OF SEALING MATERIAL | ○ | ○ | ○ | ○ | ○ | × |
| INSULATING LAYER | ○ | ○ | ○ | ○ | × | × |
| COLOR UNEVENNESS OF SEALING MATERIAL | ○ | ○ | ○ | ○ | ― | × |
| COLOR CHANGE OF SEALING MATERIAL | ○ | ○ | ○ | ○ | × | × |
| MANUFACTURING COST | ○ | ⊚ | ⊚ | ○ | ○ | × |
| SHORT CIRCUIT DUE TO FOREIGN MATTER | ⊚ | ⊚ | ⊚ | ○ | × | × |

The insulating-layer-provided sealing material (rear surface side sealing material) of the back contact solar cell module prepared in Example 1 is constituted by three layers: a transparent EVA layer, a transparent PET layer, and a transparent EVA layer. Accordingly, it is not necessary to replace a resin of the front surface (light receiving surface) side sealing material layer with a resin of the rear surface side sealing material layer. As a result, productivity of the sealing material is high.

This is true of Example 2 in which the insulating-layer-provided sealing material (rear surface side sealing material) is constituted by three layers of EMAA/white PET/EMAA, Example 3 in which the insulating layer-provided sealing material (rear surface side sealing material) is constituted by three layers of ionomer/black PET/ionomer, Example 4 in which the insulating layer-provided sealing material (rear surface side sealing material) is constituted by three layers of EVA/white olefin film (PP, PE, EVA)/EVA, and Comparative Example 1 in which the layer configuration of the sealing material is the transparent EVA single substance.

On the other hand, in Comparative Example 2, the layer configuration of the sealing material includes white colored ionomer, and thus when replacing the resin of the front surface (light receiving surface) side sealing material layer with the resin of the rear surface side sealing material, resin purging after coloring processing is necessary. Therefore, productivity of the sealing material is low.

In addition, in the case of Examples 1 to 3, the PET film is included in the insulating-layer-provided sealing material (rear surface side sealing material) as the insulating layer, and in the case of Example 4, the white olefin film (PP, PE, EVA) is included in the insulating-layer-provided sealing material (rear surface side sealing material) as the insulating layer. Accordingly, in the case of Examples 1 to 4, insulation properties are satisfactory. On the other hand, in the case of Comparative Examples 1 and 2, the insulating layer is not included in the rear surface side sealing material. Therefore, it is necessary to separately form an insulating layer, for example, on a surface of the circuit sheet and the like. As a result, the insulation properties are inferior in comparison to Examples 1 to 4.

In the case of Example 1 and Comparative Example 1, the sealing material layer is transparent, and thus color unevenness is not present in the sealing material.

In the case of Examples 2 to 4, the insulating film is a colored film. Accordingly, shading of colors does not occur in the insulating-layer-provided sealing material (rear surface side sealing material). On the other hand, in the case of Comparative Example 2, a colored resin is used as an extrusion resin to form the rear surface side sealing material, and thus a thin portion of the resin layer in the rear surface side sealing material is light in color. Therefore, the shading of colors is noticeable in the rear surface side sealing material.

In the case of Examples 1 to 4, the cell side sealing material and the circuit side sealing material are transparent, and thus it is possible to simply change the color of the rear surface side sealing material by changing the color of the insulating film. On the other hand, in the case of Comparative Examples 1 and 2, it is necessary to replace the resin of the front surface (light receiving surface) side sealing material layer with the resin of the rear surface side sealing material layer so as to change the color of the rear surface side sealing material. Therefore, in Comparative Examples 1 and 2, a lot of indirect time is necessary to change the color of the rear surface side sealing material in comparison to Examples 1 to 4. As a result, in Comparative Examples 1 and 2, the productivity of the solar cell module decreases in comparison to Examples 1 to 4.

When comparing other configurations that have an effect on the manufacturing cost, in the case of Example 1, Example 4, and Comparative Example 2, EVA containing a crosslinking agent, which is used as a resin that forms the rear surface side sealing material in the same manner as the related art. Therefore, it is necessary to use a dedicated machine that is different from a typical extruder during extrusion. As a result, in Example 1, Example 4, and Comparative Example 2, the manufacturing cost of the solar cell module is higher in comparison to other Examples and Comparative Examples.

In addition, in the case of Comparative Example 2, a colored resin is used as the resin that forms the rear surface side sealing material. Therefore, it is necessary to sufficiently perform purging during resin replacement. As a result, in Comparative Example 2, there is a concern that the manufacturing cost of the solar cell module is further raised in comparison to other Examples and Comparative Examples.

On the other hand, in the case of Examples 2 and 3, a typical transparent resin for extrusion is used as the resin that forms the rear surface side sealing material. Accordingly, a special apparatus is not necessary during extrusion. In addition, a general-use colored film is used as the insulating film. Accordingly, Examples 2 and 3 are more preferable when considering that the manufacturing cost of the solar cell module is suppressed to be very low in comparison to other Examples and Comparative Examples.

According to the back contact solar cell module relating to the embodiment of the invention, from the above-described results, it can be seen that it is possible to provide a solar cell module which has characteristics for protection of respective constituent elements of the solar cell module, which can be molded and processed by a typical method, which can be manufactured at a low cost, which is excellent in stability and durability, and which has particularly stable and high power conversion efficiency.

### Industrial Applicability

When providing an insulating film as an intermediate film on an upper surface of a circuit sheet for a back contact solar cell module in a crystalline solar cell having high photoelectric conversion efficiency instead of providing an electrical insulating layer (ILD) formed by a coating printing method that is generally employed in a printed circuit board, it is possible to supply an insulating layer having relatively higher insulation properties, it is possible to supply a colored sealing material that is simply formed by using a colored film, and it is possible to supply a solar cell module using the insulating layer and the colored sealing material.

### DESCRIPTION OF REFERENCE NUMERAL

- 100:: Solar cell module of the related art
- 101:: Solar cell module of the invention
- 1:: Transparent sealing material
- 1':: Transparent sealing material
- 2:: Insulating-layer-provided sealing material
- 2a:: Cell side sealing material
- 2b:: Circuit sheet side sealing material
- 2c:: Insulating film
- 3:: Circuit sheet (base film)
- 4:: Back sheet
- 5:: Cell electrode
- 6:: Solder or silver paste
- 7:: Interconnection pattern such as metal foil
- 8:: Transparent base material such as front glass
- 9:: Back contact cell
- 10:: Electrical insulating layer
- 11:: Through-hole

## Claims

1. A back contact solar cell module, comprising:
- a back sheet (4);
- a circuit sheet (3) laminated on the back sheet (4), the circuit sheet (3) having an interconnection pattern (7) on a front surface thereof;
- an insulating-layer-provided sealing material (2) having a through-hole (11), the insulating-layer-provided sealing material (2) being laminated on the circuit sheet (3);
- a back contact cell (9) formed on the insulating-layer-provided sealing material (2), the back contact cell (9) having a cell electrode (5) on a rear surface thereof;
- a transparent sealing material (1) laminated to cover the insulating-layer-provided sealing material (2) and the back contact cell (9);
- a transparent base material (8) laminated on the transparent sealing material (1); and
- a conductive paste (6) provided in the through-hole (11), the conductive paste (6) electrically and physically connecting the cell electrode (5) and the interconnection pattern (7) to each other;
**characterized in that** the insulating-layer-provided sealing material (2) is constituted by an insulating film (2c) and a pair of sealing material layers (2a, 2b) provided on both surfaces of the insulating film (2c); the pair of sealing material layers (2a, 2b) is construed by a cell side sealing material layer (2a) provided on the front surface of the insulating film (2c) and a circuit sheet sealing material layer (2b) provided on a rear surface of the insulating film (2c);
wherein the thickness of the cell side sealing material layer (2a) is in a range of 10 µm to 500 µm;
wherein the cell side sealing material layer (2a) comprises EVA (ethylene-vinyl acetate copolymer), EMMA (ethylene-methyl methacrylate copolymer), EAA (ethylene-acrylate copolymer), ionomer, PVB (polyvinyl butyral), or a silicon resin;
wherein the circuit sheet sealing material layer (2b) comprises EVA (ethylene-vinyl acetate copolymer), EMMA (ethylene-methyl methacrylate copolymer), EAA (ethylene-acrylate copolymer), ionomer, PVB (polyvinyl butyral), or a silicon resin; and
wherein the insulating film (2c) contains a stretched polyester film, a stretched polyamide film, a fluorine film or a polyimide film or at least one of polypropylene (homo, random, block) and polyethylene which is thermally fusible to a sealing material resin.

2. The back contact solar cell module according to claim 1, wherein the insulating film is one of a white film, a black film, and a colored film.

3. The back contact solar cell module according to claim 1, wherein the insulating film (2c) is one of a highly reflective sheet and a prism sheet.

4. The back contact solar cell module according to any one of claims 1 to 3, wherein the interconnection pattern (7) is one of aluminum foil and copper foil.

5. The back contact solar cell module according to any one of claims 1 to 4, wherein the transparent base material (8) is a glass plate.

6. The back contact solar cell module according to any one of claims 1 to 5, wherein a color of the back sheet (4) is white.

7. The back contact solar cell module according to any one of claims 1 to 6, wherein the melting point of at least one constituent resin of the cell side sealing material layer (2a) is 120 °C or lower, the melting temperature of at least one constituent resin of the insulating film (2c) is 130 °C or higher, and the melting point of at least one constituent resin of the circuit sheet sealing material layer (2b) is 120 °C or lower.

8. The back contact solar cell module according to any one of claims 1 to 6, wherein the insulating film (2c) contains a stretched polyester film, a stretched polyamide film, a fluorine film, or a polyimide.

9. The back contact solar cell module according to any one of claims 1 to 7, wherein the insulating film (2c) contains at least one of polypropylene (homo, random, block) and polyethylene, which is thermally fusible to a sealing material resin.

## Patentansprüche

1. Solarzellenmodul mit Rückseitenkontakt, das Folgendes umfasst:
- eine Rückseitenbahn (4);
- eine Schaltungsbahn (3), die auf die Rückseitenbahn (4) laminiert ist, wobei die Schaltungsbahn (3) auf einer Vorderfläche davon ein Verbindungsmuster (7) aufweist;
- ein mit einer Isolierschicht versehenes Dichtungsmaterial (2) mit einem Durchgangsloch (11), wobei das mit einer Isolierschicht versehene Dichtungsmaterial (2) auf die Schaltungsbahn (3) laminiert ist;
- eine Zelle (9) mit Rückseitenkontakt, die auf dem mit einer Isolierschicht versehenen Dichtungsmaterial (2) gebildet ist, wobei die Zelle (9) mit Rückseitenkontakt auf einer Rückfläche davon eine Zellenelektrode (5) aufweist;
- ein transparentes Dichtungsmaterial (1), das so laminiert ist, dass es das mit einer Isolierschicht versehene Dichtungsmaterial (2) und die Zelle (9) mit Rückseitenkontakt abdeckt;
- ein transparentes Trägermaterial (8), das auf das transparente Dichtungsmaterial (1) laminiert ist; und
- eine leitfähige Paste (6), die im Durchgangsloch (11) angeordnet ist, wobei die leitfähige Paste (6) die Zellenelektrode (5) und das Verbindungsmuster (7) elektrisch und physisch miteinander verbindet;
**dadurch gekennzeichnet, dass** das mit einer Isolierschicht versehene Dichtungsmaterial (2) aus einer Isolierfolie (2c) und einem Paar von Dichtungsmaterialschichten (2a, 2b) besteht, die auf beiden Flächen der Isolierfolie (2c) angeordnet sind; das Paar von Dichtungsmaterialschichten (2a, 2b) aus einer auf der Vorderfläche der Isolierfolie (2c) angeordneten Zellenseiten-Dichtungsmaterialschicht (2a) und einer auf einer Rückfläche der Isolierfolie (2c) angeordneten Schaltungsbahn-Dichtungsmaterialschicht (2b) besteht;
wobei die Dicke der Zellenseiten-Dichtungsmaterialschicht (2a) in einem Bereich von 10 µm bis 500 µm liegt;
wobei die Zellenseiten-Dichtungsmaterialschicht (2a) ein EVA (Ethylen-Vinylacetat-Copolymer), EMMA (Ethylen-Methylmethacrylat-Copolymer), EAA (Ethylen-Acrylat-Copolymer), Ionomer, PVB (Polyvinylbutyral) oder ein Siliconharz umfasst;
wobei die Schaltungsbahn-Dichtungsmaterialschicht (2b) ein EVA (Ethylen-Vinylacetat-Copolymer), EMMA (Ethylen-Methylmethacrylat-Copolymer), EAA (Ethylen-Acrylat-Copolymer), Ionomer, PVB (Polyvinylbutyral) oder ein Siliconharz umfasst und
wobei die Isolierfolie (2c) eine gestreckte Polyesterfolie, eine gestreckte Polyamidfolie, eine Fluorfolie oder eine Polyimidfolie oder ein (Homo-, statistisches, Block-)Polypropylen und/oder Polyethylen enthält, das mit einem Dichtungsmaterialharz heißschweißbar ist.

2. Solarzellenmodul mit Rückseitenkontakt nach Anspruch 1, wobei die Isolierfolie eine von einer weißen Folie, einer schwarzen Folie und einer farbigen Folie ist.

3. Solarzellenmodul mit Rückseitenkontakt nach Anspruch 1, wobei die Isolierfolie (2c) eine von einer hochreflektierenden Bahn und einer Prismenbahn ist.

4. Solarzellenmodul mit Rückseitenkontakt nach einem der Ansprüche 1 bis 3, wobei das Verbindungsmuster (7) eines von Aluminiumfolie und Kupferfolie ist.

5. Solarzellenmodul mit Rückseitenkontakt nach einem der Ansprüche 1 bis 4, wobei das transparente Trägermaterial (8) eine Glasplatte ist.

6. Solarzellenmodul mit Rückseitenkontakt nach einem der Ansprüche 1 bis 5, wobei eine Farbe der Rückseitenbahn (4) weiß ist.

7. Solarzellenmodul mit Rückseitenkontakt nach einem der Ansprüche 1 bis 6, wobei der Schmelzpunkt mindestens eines einen Bestandteil bildenden Harzes der Zellenseiten-Dichtungsmaterialschicht (2a) 120 °C oder weniger beträgt, die Schmelztemperatur mindestens eines einen Bestandteil bildenden Harzes der Isolierfolie (2c) 130 °C oder mehr beträgt und der Schmelzpunkt mindestens eines einen Bestandteil bildenden Harzes der Schaltungsbahn-Dichtungsmaterialschicht (2b) 120 °C oder weniger beträgt.

8. Solarzellenmodul mit Rückseitenkontakt nach einem der Ansprüche 1 bis 6, wobei die Isolierfolie (2c) eine gestreckte Polyesterfolie, eine gestreckte Polyamidfolie, eine Fluorfolie oder ein Polyimid enthält.

9. Solarzellenmodul mit Rückseitenkontakt nach einem der Ansprüche 1 bis 7, wobei die Isolierfolie (2c) ein (Homo-, statistisches, Block-)Polypropylen und/oder Polyethylen enthält, das mit einem Dichtungsmaterialharz heißschweißbar ist.

## Revendications

1. Module de cellule solaire à contact arrière, comprenant :
- une feuille arrière (4) ;
- une feuille de circuit (3) stratifiée sur la feuille arrière (4), la feuille de circuit (3) possédant un motif d'interconnexion (7) sur une surface avant de celle-ci ;
- un matériau d'étanchéité (2) muni d'une couche d'isolation possédant un trou traversant (11), le matériau d'étanchéité (2) muni d'une couche d'isolation étant stratifié sur la feuille de circuit (3) ;
- une cellule de contact arrière (9) formée sur le matériau d'étanchéité (2) muni d'une couche d'isolation, la cellule de contact arrière (9) possédant une électrode de cellule (5) sur une surface arrière de celle-ci ;
- un matériau d'étanchéité transparent (1) stratifié pour recouvrir le matériau d'étanchéité (2) muni d'une couche d'isolation et la cellule de contact arrière (9) ;
- un matériau de base transparent (8) stratifié sur le matériau d'étanchéité transparent (1) ; et
- une pâte conductrice (6) placée dans le trou traversant (11), la pâte conductrice (6) reliant électriquement et physiquement l'électrode de cellule (5) et le motif d'interconnexion (7) l'une à l'autre ;
**caractérisé en ce que** le matériau d'étanchéité (2) muni d'une couche d'isolation est constitué d'un film isolant (2c) et d'une paire de couches (2a, 2b) de matériau d'étanchéité placées sur les deux surfaces du film isolant (2c) ; la paire de couches (2a, 2b) de matériau d'étanchéité étant définie par une couche (2a) de matériau d'étanchéité côté cellule placée sur la surface avant du film isolant (2c) et une couche (2b) de matériau d'étanchéité de feuille de circuit placée sur une surface arrière du film isolant (2c) ; l'épaisseur de la couche (2a) de matériau d'étanchéité côté cellule étant dans une plage de 10 µm à 500 µm ;
la couche (2a) de matériau d'étanchéité côté cellule comprenant un EVA (copolymère d'éthylène-acétate de vinyle), un EMMA (copolymère d'éthylène-méthacrylate de méthyle), un EAA (copolymère d'éthylène-acrylate), un ionomère, un PVB (poly(butyral de vinyle)) ou une résine de silicone ;
la couche (2b) de matériau d'étanchéité de feuille de circuit comprenant un EVA (copolymère d'éthylène-acétate de vinyle), un EMMA (copolymère d'éthylène-méthacrylate de méthyle), un EAA (copolymère d'éthylène-acrylate), un ionomère, un PVB (poly(butyral de vinyle)) ou une résine de silicone ; et
le film isolant (2c) contenant un film de polyester étiré, un film de polyamide étiré, un film au fluor ou un film de polyimide ou au moins l'un parmi un polypropylène (homopolymère, statistique, à blocs) et un polyéthylène qui est thermiquement fusible à une résine de matériau d'étanchéité.

2. Module de cellule solaire à contact arrière selon la revendication 1, le film isolant étant l'un parmi un film blanc, un film noir et un film coloré.

3. Module de cellule solaire à contact arrière selon la revendication 1, le film isolant (2c) étant l'une parmi une feuille hautement réfléchissante et une feuille prismatique.

4. Module de cellule solaire à contact arrière selon l'une quelconque des revendications 1 à 3, le motif d'interconnexion (7) étant l'une parmi une feuille d'aluminium et une feuille de cuivre.

5. Module de cellule solaire à contact arrière selon l'une quelconque des revendications 1 à 4, le matériau de base transparent (8) étant une plaque de verre.

6. Module de cellule solaire à contact arrière selon l'une quelconque des revendications 1 à 5, une couleur de la feuille arrière (4) étant blanche.

7. Module de cellule solaire à contact arrière selon l'une quelconque des revendications 1 à 6, le point de fusion d'au moins une résine constituante de la couche (2a) de matériau d'étanchéité côté cellule étant de 120 °C ou moins, la température de fusion d'au moins une résine constituante du film isolant (2c) étant de 130 °C ou plus, et le point de fusion d'au moins une résine constituante de la couche (2b) de matériau d'étanchéité de feuille de circuit étant de 120 °C ou moins.

8. Module de cellule solaire à contact arrière selon l'une quelconque des revendications 1 à 6, le film isolant (2c) contenant un film de polyester étiré, un film de polyamide étiré, un film au fluor ou un polyimide.

9. Module de cellule solaire à contact arrière selon l'une quelconque des revendications 1 à 7, le film isolant (2c) contenant au moins l'un parmi un polypropylène (homopolymère, statistique, à blocs) et un polyéthylène, qui est thermiquement fusible à une résine de matériau d'étanchéité.
